# EUROPEAN PATENT APPLICATION

(11) **EP 2 960 948 A1**
(43) Date of publication of application: **30.12.2015**
(21) Application number: 15171356.7
(22) Date of filing: 10.06.2015
(51) Int. Cl.: H01L 31/0352, H01L 31/07

(54) **ENERGY HARVESTER**

(30) Priority: 26.06.2014 US 201414316671
(71) Applicant: NXP B.V., 5656 AG Eindhoven (NL)
(72) Inventor: Long, Ethan, Redhill, Surrey RH1 1SH (GB)
(74) Representative: Hardingham, Christopher Mark

(57) **Abstract**

In one or more disclosed embodiments a circuit is configured and arranged to harvest photonic energy. The circuit includes a quantum stack having a plurality of quantum confinement regions. The quantum confinement regions are separated from each other by one or more quantum barrier regions. Each of the quantum confinement regions includes semiconductor material that creates charge carriers therein in response to light. The circuit includes a first contact connected to a lower layer of the quantum stack and a second contact connected to an upper layer of the quantum stack. The circuit also includes a passive circuit configured and arranged to generate an electric field contacting the quantum stack, thereby inducing the charge carriers to migrate toward one of the first and second contacts.

## Description

Aspects of various embodiments are directed to semiconductor devices, and more particularly to photosensitive semiconductor devices.

Various example embodiments are directed to energy harvesting circuits and their manufacture. In one or more disclosed embodiments a circuit is configured and arranged to harvest photonic energy. The circuit includes a quantum stack having a plurality of quantum confinement regions. The quantum confinement regions are separated from each other by one or more quantum barrier regions. Each of the quantum confinement regions and the adjacent quantum barrier regions include semiconductor materials configured and arranged to create charge carriers therein. The circuit includes a first contact connected to a lower layer of the quantum stack and a second contact connected to an upper layer of the quantum stack. The circuit also includes a passive circuit configured and arranged to generate an electric field that causes the charge carriers in the quantum stack to migrate toward one of the first and second contacts.

Methods are also disclosed for the manufacture of a semiconductor device, consistent with one or more embodiments. A first ohmic contact is placed on a first region of a substrate. A passive circuit, a quantum stack, and a second ohmic contact are stacked on a second region of the substrate. The quantum stack includes a plurality of quantum confinement regions separated from each other by one or more quantum barrier regions. Each of the quantum confinement regions and the adjacent quantum barrier regions include semiconductor materials configured and arranged to create charge carriers therein. The passive circuit is configured and arranged to generate an electric field that causes the charge carriers in the quantum stack to migrate toward one of the first and second contacts.

The above discussion/summary is not intended to describe each embodiment or every implementation of the present disclosure. The figures and detailed description that follow also exemplify various embodiments.

Various example embodiments may be more completely understood in consideration of the following detailed description in connection with the accompanying drawings, in which:
FIG. 1 shows a first energy harvesting device, consistent with one or more embodiments;
FIG. 2 shows a second energy harvesting device, consistent with one or more embodiments;
FIG. 3 shows a third energy harvesting device, consistent with one or more embodiments;
FIG. 4 shows a device having a first arrangement of a quantum stack, a passive electric field generator, and contacts on a substrate, consistent with one or more embodiments; and
FIG. 5 shows a device having a second arrangement of a quantum stack, a passive electric field generator, and contacts on a substrate, consistent with one or more embodiments.

While various embodiments discussed herein are amenable to modifications and alternative forms, aspects thereof have been shown by way of example in the drawings and will be described in detail. It should be understood, however, that the intention is not to limit the invention to the particular embodiments described. On the contrary, the intention is to cover all modifications, equivalents and alternatives falling within the scope of the disclosure including aspects defined in the claims. In addition, the term "example" as used throughout this application is only by way of illustration, and not limitation.

Aspects of the present disclosure are believed to be applicable to a variety of different types of apparatuses, systems and methods involving energy harvesting. Some example implementations are directed to circuits, apparatuses and methods for harvesting photonic and/or thermal energy. While the disclosed embodiments are not necessarily limited to such applications, various aspects of the present disclosure may be appreciated through a discussion of various examples using this context.

Some photosensitive devices include one or more layers of a semiconductor material that generates charge carriers when struck by photons of light. These devices use an externally provided voltage to create an electric field to propel the charge carriers toward an output terminal and induce a measurable current. Such a device may be used, for example, as an optical sensor. However, the need for an externally provided voltage to induce a current limits suitable application of such photosensitive devices. For example, the need for an externally provided voltage may render the photosensitive devices unsuitable for use as an optical sensor to wake up a powered down device (*e.g*., when motion is detected). As another example, the need for an externally provided voltage may render the photosensitive devices inefficient for power generation applications (*e.g*., solar cells).

In some various embodiments, an apparatus includes a semiconductor arrangement that is configured to create charge carriers therein in response to light in a range of target wavelengths. The apparatus also includes a passive circuit configured to generate an electric field, and thereby induce the charge carriers to migrate toward an output terminal or contact of the apparatus. Passive circuits operate without being provided with an external voltage or current. Circuits that require an external voltage or current for operation are referred to as active circuits.

In some embodiments, an apparatus includes a semiconductor arrangement referred to herein as a quantum stack. A quantum stack includes a plurality of quantum confinement regions separated from each other by one or more quantum barrier regions. Each of the quantum confinement regions and the adjacent quantum barrier regions include semiconductor materials configured and arranged to create charge carriers therein in response to light in a range of target wavelengths.

The apparatus includes a first contact connected to a lower layer of the quantum stack and a second contact connected to an upper layer of the quantum stack. The apparatus also includes a passive circuit configured and arranged to generate an electric field contacting the quantum stack, thereby inducing the charge carriers to migrate toward one of the first and second contacts.

In some embodiments, the passive circuit includes a P-N diode connected between one of the first and second contacts and the quantum stack. A P-N diode includes a portion of n-type semiconductor (which has an excess of valence electrons) adjacent to a portion of p-type semiconductor (which has a deficit of valence electrons, leaving "holes" in their place). Due to the adjacency of the n-type and p-type semiconductor portions, spare electrons of the n-type semiconductor portion may diffuse into the p-type semiconductor portion. Similarly, holes from the p-type semiconductor may diffuse into the n-type semiconductor portion. As a result, the n-type semiconductor portion of the diode becomes positively charged and the p-type semiconductor portion of the diode becomes negatively charged-thereby creating an electric field. In some implementations, the passive circuit is placed in a location adjacent to the quantum stack, such that the quantum stack is located within the electric field generated by the passive circuit.

In some embodiments, the passive circuit includes a Schottky diode connected between one of the first and second contacts and the quantum stack. A Schottky diode includes a portion of metal adjacent to a portion of semiconductor. Due to the adjacency of the metal and semiconductor portions, the Fermi energy levels of the metal and semiconductor portions are aligned, while the conduction and valence energy levels in the semiconductor portion are bent. As a result, a space charge region is formed, thereby creating an electric field. In some implementations, the passive circuit is placed in a location adjacent to the quantum stack, such that the quantum stack is located within the electric field generated by the passive circuit.

Various semiconductors that may be used for the quantum confinement regions and quantum barrier regions include, but are not limited to, Si, Ge, SiGe, SiC, SiGeSn, InP, GaAs, HgCdTe, GaN, SiGeC, ZnCdO, InSnO, and/or ZnSnO. In some implementations the plurality of quantum confinement regions in the quantum stack include a first semiconductor with a first bandgap and the one or more quantum barrier regions include a second semiconductor with a second bandgap. For example, the first semiconductor may be SiₓGe₁₋ₓ, and the second semiconductor may be Si_{y}Ge_{1-y}.

For ease of explanation, the examples and embodiments are primarily described with reference to harvesting energy from light in the infrared frequency range. However, the embodiments are not so limited. In various embodiments, the quantum stack may be adapted to generate charge carriers in response to other wavelengths (visible and/or invisible) alone or in combination. In some implementations, the quantum stack may also be configured to convert thermal energy into charge carriers.

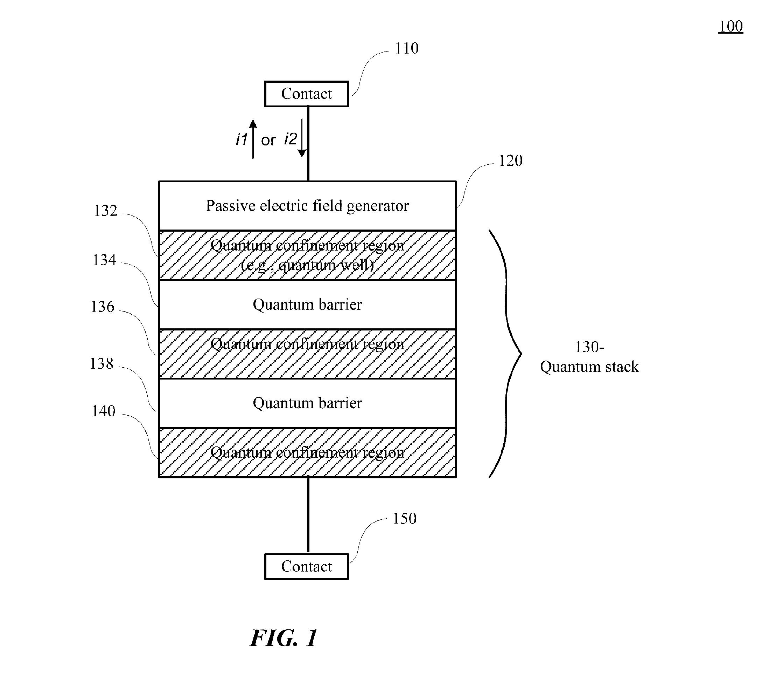

Turning now to the figures, FIG. 1 shows a first energy harvesting device, consistent with one or more embodiments.

The device 100 includes a quantum stack 130 having a plurality of quantum confinement regions 132, 136 and 140, which are separated from each other by quantum barrier regions 134 and 138. The quantum confinement regions 132, 136 and 140 include a semiconductor material that creates charge carriers therein in response to light of a target frequency (*e.g*., infrared light). In one example implementation, the quantum confinement regions are SiGe and quantum barrier regions are Si. However, as indicated above, other semiconductors may be used for the quantum confinement and quantum barrier regions.

The apparatus also includes contacts 110 and 150 and a passive electric field generator 120. A first one of the contacts is electrically connected to an upper layer 132 of the quantum stack 130. In this example, a second one of the contacts 150 is electrically connected to a lower layer 140 or the quantum stack 130. In this example, the passive electric field generator 120 electrically connects contact 110 to an upper layer of the quantum stack 130 (*e.g*., quantum confinement region 132). In some other implementations, the passive electric field generator 120 may electrically connect contact 150 to the lower layer of the quantum stack 130 (*e.g.,* quantum confinement region 140).

The passive electric field generator 120 includes passive circuitry configured to generate an electric field without an externally applied voltage or current. In some implementations, passive electric field generator 120 may include a P-N diode configured to generate an electric field. As explained above, the electric field causes the charge carriers generated in the quantum confinement regions 132, 136 and 140 to migrate toward one of the contacts 110 or 150 to induce a current (i1 or i2). The direction of the current depends, for example, on the orientation of the P-N diode in the passive electric field generator 120.

In this example, the quantum stack 130 includes three quantum confinement regions 132, 136 and 140 and two quantum barrier regions 134 and 138. However, the quantum stack 130 may include other numbers of quantum confinement regions and/or quantum barrier regions. Similarly, although the quantum confinement regions 132, 136 and 140 and quantum barrier regions 134 and 138 in FIG. 1 are layers in the quantum stack 130, the quantum confinement and quantum barrier regions may have other shapes and/or arrangements.

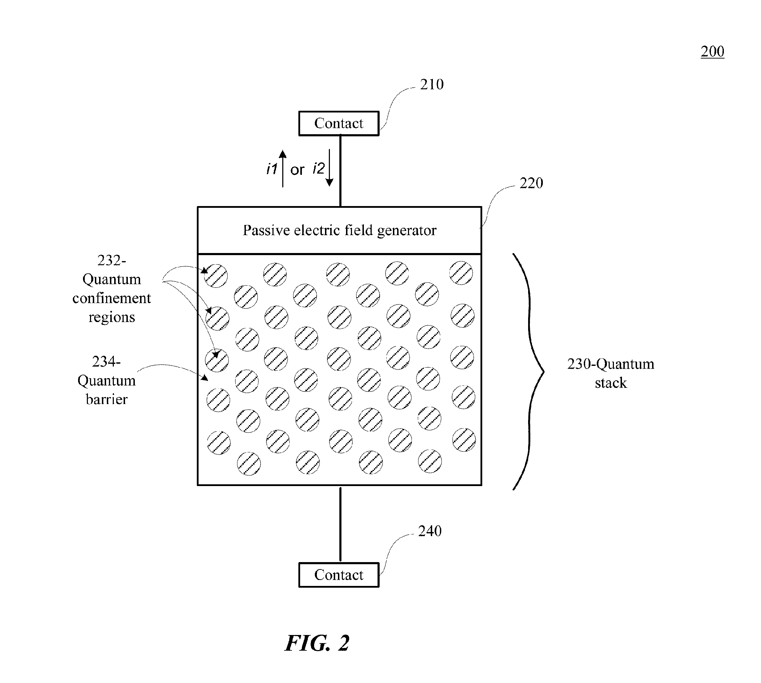

FIG. 2 shows a second energy harvesting device, consistent with one or more embodiments. The device 200 includes a quantum stack 230, a passive electric field generator 220, and contacts 210 and 240 arranged similar to the quantum stacks 130, 120 and contacts 110 and 150 discussed with reference to FIG. 1. However, the quantum stack 230 includes a different arrangement of quantum confinement and quantum barrier regions in comparison to the quantum stack 130. In this example, the quantum confinement regions 232 are quantum dots dispersed in and separated by the quantum barrier region 234. The passive electric field generator 220 generates an electric field, thereby causing the charge carriers generated in the quantum confinement regions 232 to migrate toward one of the contacts 210 or 240 to induce a current (i1 or i2).

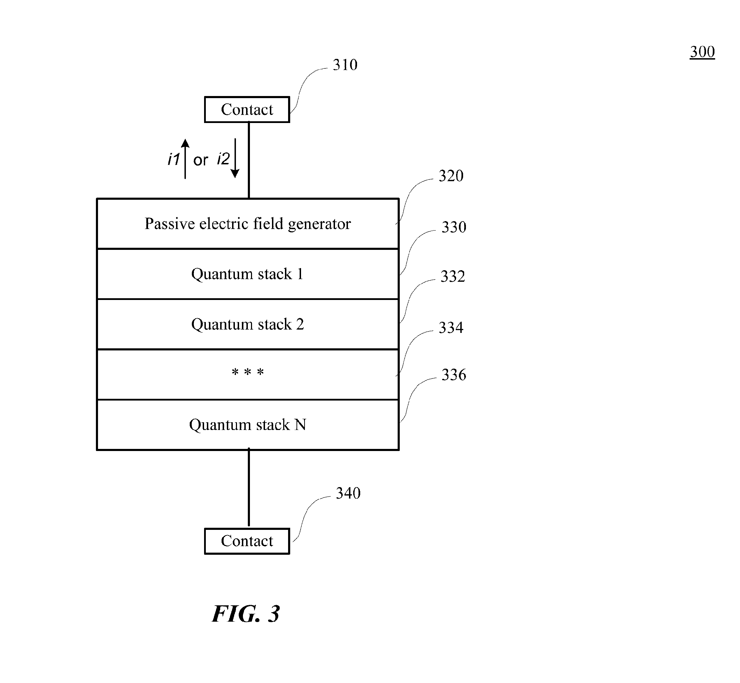

FIG. 3 shows a third energy harvesting device, consistent with one or more embodiments. The device 300 includes multiple quantum stacks 330, 332, 334 and 336 connected in series between a first contact 310 and a second contact 340. The quantum stacks 330, 332, 334 and 336 may be implemented, for example, as described with reference to quantum stack 130 in FIG. 1 or quantum stack 230 in FIG. 2. In some implementations, each of the quantum stacks 330, 332, 334 and 336 may be arranged to harvest energy from light of a different wavelength. In some other implementations, multiple ones of the quantum stacks 330, 332, 334 and 336 may harvest energy from light of the same wavelength.

The device 300 also includes a passive electric field generator 320, which electrically connects contact 310 to one of the quantum stacks 330. The passive electric field generator 320 generates an electric field, thereby causing the charge carriers generated in the quantum confinement regions of the quantum stacks 330, 332, 334 and 336 to migrate toward one of the contacts 310 or 340 to induce a current (i1 or i2).

The example devices shown in FIGs. 1, 2 and 3, each include a single passive electric field generator connected to one end of a quantum stack. In some implementations, a device may include multiple passive electric field generators. For example, the device shown in FIG. 3 may include a second passive electric field generator connected between contact 340 and quantum stack 336. As another example, the device shown in FIG. 3 may include a respective passive electric field generator connected between each of the quantum stacks 330, 332, 334 and 336.

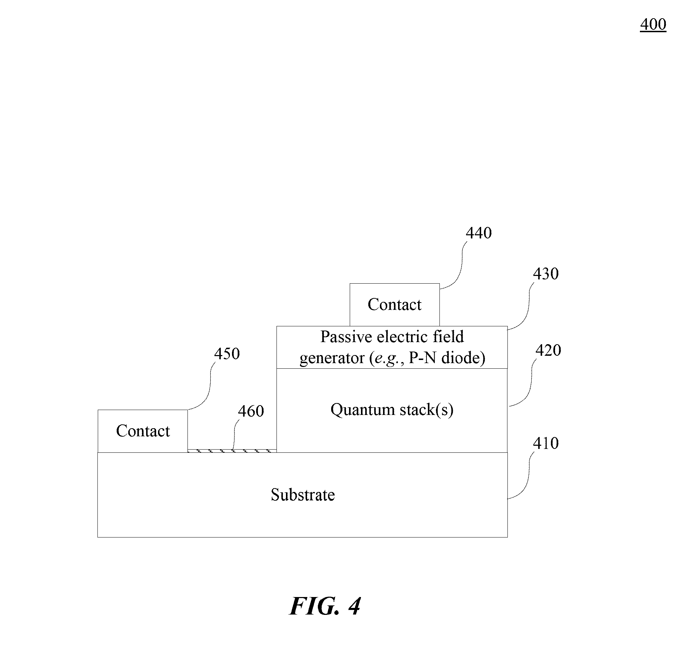

FIG. 4 shows a device having a first arrangement of a quantum stack, a passive electric field generator, and contacts on a substrate, consistent with one or more embodiments. In this device 400, a first contact 450 is placed on a first region of a substrate 410. One or more quantum stacks 420, a passive electric field generator *(e.g.,* a P-N diode) 430, and a second contact 440 are stacked on a second region of the substrate. The quantum stack(s) may be implemented, for example, as described with reference to quantum stack 130 in FIG. 1 or quantum stack 230 in FIG. 2. The contact 450 is electrically connected to a lower layer of quantum stack(s) via a signal line 460 *(e.g.,* a metallic or poly-silicon signal line) placed on the substrate 410.

The device 400 may be manufactured by sequentially forming or placing the various elements on the substrate or one another. In accordance with some embodiments, quantum stack(s) 420 are formed or placed on the second region of the substrate 410. The passive electric field generator 430 is then placed or formed on top of the quantum stack(s) 420. Alternatively, the passive electric field generator 430 may be placed or formed on the quantum stack(s) 420 prior to placing the quantum stack(s) 420 on the substrate 410. The contact 440 is formed or placed on top of the passive electric field generator 430. The contact 450 is formed in the first region of the substrate. The contact 450 is electrically connected to a lower layer of quantum stack(s) via a signal line 460 *(e.g.,* a metallic or poly-silicon signal line). In various embodiments, the signal line 460 and contact 450 may be placed or formed on the substrate 410, at various times in the above described method of manufacture.

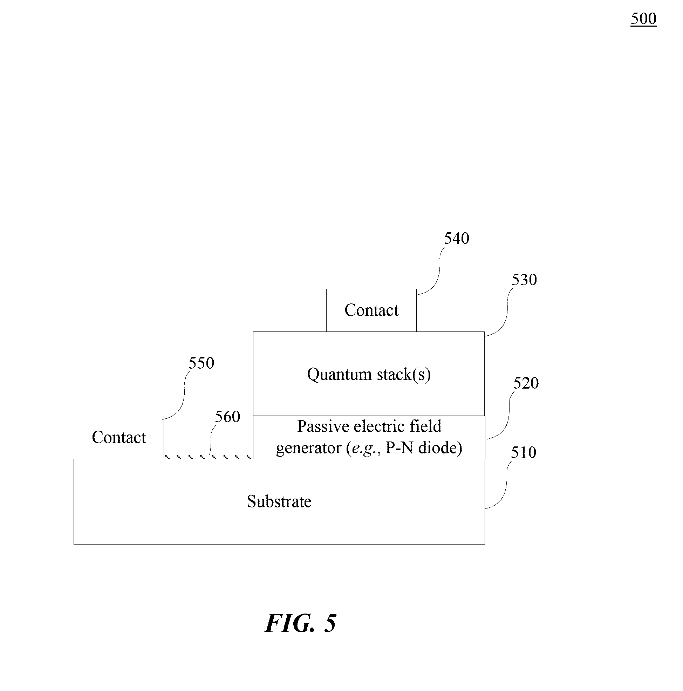

FIG. 5 shows a device having a second arrangement of a quantum stack, a passive electric field generator, and contacts on a substrate, consistent with one or more embodiments. In this device 500, a first contact 550 is placed on a first region of a substrate 510. A passive electric field generator 520, one or more quantum stacks 530, and a second contact 540 are stacked on a second region of the substrate. The quantum stack(s) 530 may be implemented, for example, as described with reference to quantum stack 130 in FIG. 1 or quantum stack 230 in FIG. 2. The contact 550 is electrically connected to a lower layer of quantum stack(s) via a signal line 560 placed on the substrate 510.

The device 500 may be manufactured by sequentially forming or placing the various elements on the substrate or one another. In accordance with some embodiments, the passive electric field generator 520 is first placed on the second region of the substrate 510. The quantum stack(s) 530 are formed or placed on the passive electric field generator 520. Alternatively, the quantum stack(s) 530 may be placed or formed on the passive electric field generator 520 prior to placing the passive electric field generator 520 on the substrate. The contact 540 is formed or placed on top of the quantum stack(s) 530. The contact 550 is formed or placed in the first region of the substrate 510 and the contact 550 is electrically connected to a lower layer of quantum stack(s) via a signal line 560 *(e.g.,* a metallic or poly-silicon signal line). In various embodiments, the signal line 560 and contact 550 may each be placed or formed on the substrate 510, at various times in the above described method of manufacture.

Various blocks, modules or other circuits may be implemented to carry out one or more of the operations and activities described herein and/or shown in the figures. In these contexts, a "block" (also sometimes "logic circuitry" or "module") is a circuit that carries out one or more of these or related operations/activities *(e.g.,* electric field generation or charge carrier generation). For example, in certain of the above-discussed embodiments, one or more modules are discrete logic circuits or programmable logic circuits configured and arranged for implementing these operations/activities, as in FIGs. 1, 2 and 3.

Based upon the above discussion and illustrations, those skilled in the art will readily recognize that various modifications and changes may be made to the various embodiments without strictly following the exemplary embodiments and applications illustrated and described herein. For example, although aspects and features may in some cases be described in individual figures, it will be appreciated that features from one figure can be combined with features of another figure even though the combination is not explicitly shown or explicitly described as a combination. Such modifications do not depart from the true spirit and scope of various aspects of the invention, including aspects set forth in the claims.

## Claims

1. An apparatus, comprising a circuit configured and arranged to harvest photonic energy, the circuit including:
a quantum stack including a plurality of quantum confinement regions separated from each other by one or more quantum barrier regions, each of the quantum confinement regions includes a semiconductor material configured to create charge carriers therein;
a first contact connected to a lower layer of the quantum stack and a second contact connected to an upper layer of the quantum stack; and
a passive circuit configured and arranged to generate an electric field that causes the charge carriers in the quantum stack to migrate toward one of the first and second contacts.

2. The apparatus of claim 1, wherein the semiconductor material in each of the quantum confinement regions is configured to create the charge carriers therein in response to infrared light.

3. The apparatus of any preceding claim, wherein the passive circuit includes a diode connected between one of the first and second contacts and the quantum stack, the one of the first and second contacts being connected to the quantum stack via the diode.

4. The apparatus of any preceding claim, wherein the passive circuit is adjacent to the quantum stack such that the quantum stack may be within the electric field generated by the passive circuit.

5. The apparatus of any preceding claim, wherein the semiconductor materials of each of the quantum confinement regions and the quantum barrier regions are further configured and arranged to convert thermal energy into charge carriers.

6. The apparatus of any preceding claim, wherein the plurality of quantum confinement regions include a first semiconductor with a first bandgap and the one or more quantum barrier regions include a second semiconductor with a second bandgap.

7. The apparatus of claim 6, wherein the first semiconductor is SiₓGe₁₋ₓ, and the second semiconductor is Si_{y}Ge_{1-y}.

8. The apparatus of any preceding claim, wherein each of the plurality of quantum confinement regions includes at least one of a respective quantum well and a respective quantum dot.

9. The apparatus of any preceding claim, further comprising an energy storage device connected to receive a current via the first and second contacts.

10. A method of manufacture, comprising:
placing a first ohmic contact on a first region of a substrate; and
stacking a passive circuit, a quantum stack, and a second ohmic contact on a second region of the substrate, wherein
the quantum stack includes a plurality of quantum confinement regions separated from each other by one or more quantum barrier regions, each of the quantum confinement regions includes semiconductor material that creates charge carriers; and
the passive circuit is configured and arranged to generate an electric field that causes the charge carriers in the quantum stack to migrate toward one of the first and second contacts.

11. The method of claim 10, wherein the semiconductor material in each of the quantum confinement regions is configured to create the charge carriers therein in response to infrared light.

12. The method of claim 10 or 11, further comprising electrically connecting the first ohmic contact to the quantum stack to the passive circuit; and
wherein the stacking of the passive circuit, the quantum stack, and the second ohmic contact includes:
placing the passive circuit on top of the substrate;
placing the quantum stack on top of the passive circuit; and
placing the second ohmic contact on the quantum stack.

13. The method of any of claims 10 to 12, or an apparatus according to any of claims 1 to 9, wherein the passive circuit includes a P-N diode.

14. The method of any of claims 10 to 12, or an apparatus according to any of claims 1 to 9, wherein the passive circuit includes a Schottky diode.

15. The method of any of claims 10 to 12, wherein the plurality of quantum confinement regions include a first semiconductor with a first bandgap and the one or more quantum barrier regions include a second semiconductor with a second bandgap.
